# EUROPEAN PATENT APPLICATION

(11) **EP 4 664 693 A1**
(43) Date of publication of application: **17.12.2025**
(21) Application number: 23930811.7
(22) Date of filing: 07.11.2023
(51) Int. Cl.: H01S 5/14, G02B 6/26, G02F 1/29, G02F 1/365

(54) **LIGHT SOURCE DEVICE**

(30) Priority: 28.03.2023 JP 2023051326
(71) Applicant: Hamamatsu Photonics K.K., Hamamatsu-shi, Shizuoka 435-8558 (JP)
(72) Inventor: KATO, Naoaki, Hamamatsu-shi, Shizuoka 435-8558 (JP); TAKIGUCHI, Yuu, Hamamatsu-shi, Shizuoka 435-8558 (JP); TANAKA, Hiroshi, Hamamatsu-shi, Shizuoka 435-8558 (JP)
(74) Representative: Grünecker Patent- und Rechtsanwälte PartG mbB
(86) International application number: PCT/JP2023/040063
(87) International publication number: WO 2024/202182

(57) **Abstract**

A light source apparatus includes: a light source configured to output light; an optical fiber to which the light output from the light source is input and which outputs the light; a spatial light modulator including an input unit for a control signal and configured to be able to control distribution of angles at which incident light is reflected based on the control signal; and a diffraction grating configured to disperse the light output from the optical fiber to cause the light to be incident on the spatial light modulator, and return at least a part of the light reflected by the spatial light modulator to the light source. An optical resonator is formed by the light source and the spatial light modulator, and the light returned to the light source is output.

## Description

### Technical Field

One aspect of the present disclosure relates to a light source apparatus.

### Background Art

Patent Literature 1 describes a Littman/Metcalf type external resonator semiconductor laser. The external resonator semiconductor laser of Patent Literature 1 is configured to obtain a wide spectrum (bandwidth) by changing an end mirror to a concave mirror and making a curvature radius thereof equal to a distance between the concave mirror and a diffraction grating.

### Citation List

### Patent Literature

Patent Literature 1: Specification of US Patent No. 7245642

### Summary of Invention

### Technical Problem

In the external resonator semiconductor laser described above, light having a comb-like spectrum including, for example, a Fabry-Perot mode is output. An interval (longitudinal mode interval) between combs adjacent to each other increases, so that the continuity of such a comb-like spectrum is reduced.

An aspect of the present disclosure has been made in view of the above circumstances, and provides a light source apparatus capable of forming a dense spectrum by reducing the longitudinal mode interval.

### Solution to Problem

(1) A light source apparatus according to one aspect of the present disclosure includes: a light source configured to output light; an optical fiber to which the light output from the light source is input and which outputs the light; a reflection unit including an input unit for a control signal and configured to be able to control distribution of angles at which incident light is reflected based on the control signal; and a diffraction grating configured to disperse the light output from the optical fiber to cause the light to be incident on the reflection unit, and configured to return, to the light source, at least a part of the light reflected by the reflection unit, wherein an optical resonator including the light source and the reflection unit is formed, and the light returned to the light source is output.
   In the light source apparatus according to one aspect of the present disclosure, the light output from the light source reaches the diffraction grating via the optical fiber, is dispersed in the diffraction grating and incident on the reflection unit. Then, at least a part of the light reflected by the reflection unit is returned from the diffraction grating to the light source, and the light returned to the light source is output. As described above, since the optical fiber is provided between the light source and the diffraction grating, the length of the optical resonator (optical resonator length) formed, which includes the light source and the reflection unit, is longer than that in a configuration in which the optical fiber is not provided. As a result, the longitudinal mode interval of a comb-like spectrum in the output light is reduced to bring the spectrum close to a continuous shape, and thus a dense spectrum can be formed. By increasing the optical resonator length with the optical fiber, it is possible to form the dense spectrum while securing optical stability. By forming the dense spectrum, wavelength resolution can be increased, and detection accuracy in spectroscopy such as absorption spectroscopy can be improved.
(2) In the light source apparatus according to the above (1), the optical fiber may be a single-mode fiber or a highly non-linear fiber. According to such a configuration, a non-linear effect is likely to occur in the optical fiber. Examples of the non-linear effect include self-phase modulation, cross-phase modulation, modulation instability, stimulated Raman scattering, stimulated Brillouin scattering, four-wave mixing, supercontinuum generation, and the like. By using these non-linear effects, a degree of freedom of spectrum control of light is improved, for example, by further expanding the spectrum.
(3) In the light source apparatus according to the above (1) or (2), the optical fiber may be a dispersion compensation fiber or a zero dispersion wavelength fiber. According to such a configuration, the wavelength dependency of the longitudinal mode interval is reduced, and each longitudinal mode interval can be made uniform.
(4) In the light source apparatus according to the above (1) to (3), a length of the optical fiber may be 0.1 times or more a length of the optical resonator in a case where the optical fiber is not provided. When the optical fiber has a sufficient length as described above, the optical fiber can appropriately increase the optical resonator length to form the dense spectrum.
(5) In the light source apparatus according to the above (4), the length of the optical fiber may be 10 times or more a length of the optical resonator in a case where the optical fiber is not provided. According to such a configuration, the optical fiber can be made longer, and a denser spectrum can be formed.
(6) In the light source apparatus according to the above (1) to (5), a length of the optical fiber may be 10 mm or more. When the optical fiber has a sufficient length as described above, the optical fiber can appropriately increase the optical resonator length to form the dense spectrum. In order to obtain the non-linear effect, the optical fiber may have a length of about several mm.
(7) In the light source apparatus according to the above (6), a length of the optical fiber may be 1 m or more. According to such a configuration, the optical fiber can be made longer, and a denser spectrum can be formed.
(8) The light source apparatus according to any one of the above (1) to (7) may further include: a first lens configured to condense the light output from the light source to one end of the optical fiber; and a second lens configured to condense the light returned from the diffraction grating to another end of the optical fiber. As described above, by adopting the configuration in which the light incident on both end portions of the optical fiber is condensed by the lens, the replacement of the optical fiber and the like can be easily performed.
(9) In the light source apparatus according to any one of the above (1) to (8), a bandwidth of the light returned from the diffraction grating to the light source may be controlled by controlling distribution of angles of the light reflected by the reflection unit based on the control signal. According to such a configuration, by changing the control signal, the distribution of angles at which the light is reflected by the reflection unit is changed, and the bandwidth of the light returned from the diffraction grating to the light source can be changed. That is, according to such a configuration, the bandwidth of the light returned from the diffraction grating to the light source can be arbitrarily adjusted. After the bandwidth of the light is adjusted, the longitudinal mode interval in the adjusted bandwidth can be reduced.

### Advantageous Effects of Invention

An aspect of the present disclosure can provide a light source apparatus capable of forming a dense spectrum by reducing a longitudinal mode interval.

### Brief Description of Drawings

FIG. 1 is a diagram schematically illustrating a light source apparatus according to the present embodiment.
FIG. 2 is a diagram illustrating an example of a modulation pattern displayed on a spatial light modulator.
FIG. 3 is a diagram illustrating an effect of increasing an optical resonator length.

### Description of Embodiments

Hereinafter, the present embodiment will be described in detail with reference to the drawings. Note that, in the drawings, the same or corresponding parts are denoted by the same reference signs, and redundant description will be omitted.

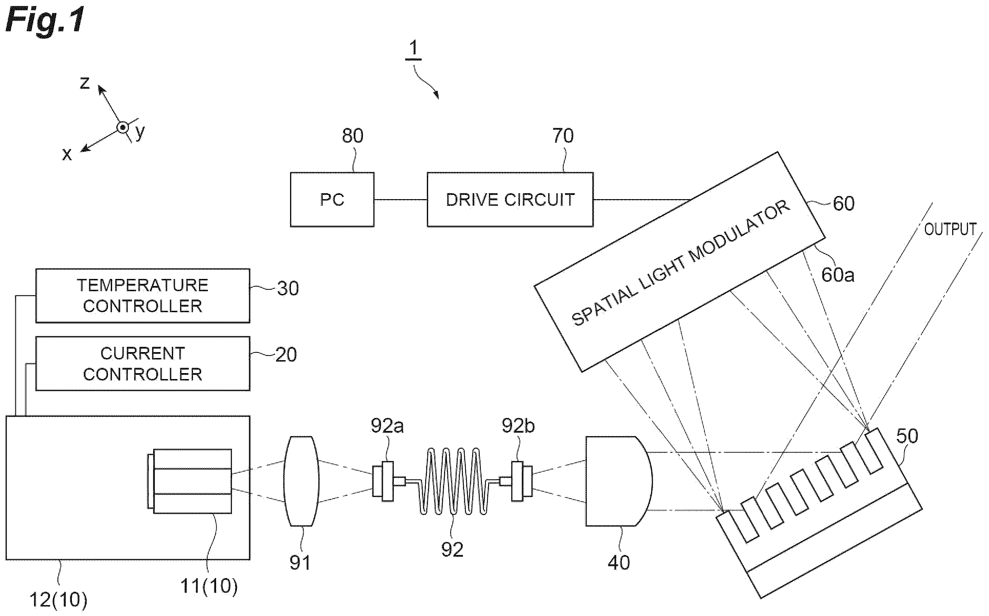

FIG. 1 is a diagram schematically illustrating a light source apparatus 1 according to a first embodiment. The light source apparatus 1 is an external cavity laser (ECL). The light source apparatus 1 is, for example, a Littman-type external cavity laser, and is configured to reflect +1-order light of a diffraction grating by a mirror and return the light into a semiconductor laser.

As illustrated in FIG. 1, the light source apparatus 1 includes a light source unit 10, a current controller 20, a temperature controller 30, a lens 40 (second lens), a diffraction grating 50, a spatial light modulator 60 (reflection unit), a drive circuit 70, a PC 80, a lens 91 (first lens), and an optical fiber 92.

The light source unit 10 includes a light source 11 and an LD mount 12. The light source 11 is, for example, a semiconductor laser (LD: Laser Diode) that outputs light having a spontaneous emission spectrum having a center wavelength of 850 nm. The center wavelength of the light output from the light source 11 may be 10 nm or more and 3 mm or less. The light source 11 may be, for example, a Fabry-Perot type semiconductor laser. An end surface of the light source 11 on a side coupled to an external resonator (light output direction side) may be provided with an antireflection coating. The light source 11 is mounted on the LD mount 12. The LD mount 12 may be a mount with a thermoelectric cooler (TEC). In the light source apparatus 1, an optical resonator is formed by the light source 11 and the spatial light modulator 60 (described later). In the light source apparatus 1, the light returned to the light source 11 through the external resonator is output.

The current controller 20 is configured to supply a current to the light source 11 via the LD mount 12 to cause the light source 11 to output light. That is, the light source 11 outputs light corresponding to the current (injection current) supplied from the current controller 20. The light source 11 generates laser oscillation or operates at an oscillation threshold or less according to the supplied (injected) current value.

The temperature controller 30 is configured to control heat absorption (or heat dissipation) of the TEC by supplying a current to the TEC provided in the LD mount 12 and to keep a temperature of the light source 11 constant via the TEC.

The lens 40 is a lens that efficiently couples the light output from the light source 11 to the optical fiber 92 when the light returns through the diffraction grating 50 and the spatial light modulator 60 (one round in the external resonator). That is, the lens 40 condenses the light returned from the diffraction grating 50 to a second end portion 92b (the other end) of the optical fiber 92. When the light emitted from the second end portion 92b of the optical fiber 92 spreads greatly, the beam diameter and divergence angle of the light are adjusted by the lens 40. A position of the lens 40 may be fixed at a position where a high light output can be obtained regardless of a focal length of a modulation pattern (phase pattern) displayed on the spatial light modulator 60.

The diffraction grating 50 is configured to disperse light having various wavelengths and output from the light source 11 to cause the light to be incident on the spatial light modulator 60, and return at least a part of the light reflected by the spatial light modulator 60 to the light source 11. In the diffraction grating 50, light is divided for each wavelength, and +1-order light is directed to the spatial light modulator 60 and 0th order light is extracted as output light.

The spatial light modulator 60 includes an input unit for a control signal, and displays the modulation pattern based on the control signal to control the distribution of angles at which the incident light is reflected. The spatial light modulator 60 is, for example, a spatial light modulator (SLM) of a reflective liquid crystal on silicon (LCOS). The modulation pattern (phase pattern) is generated by the PC 80, input from the PC 80 to the drive circuit 70, and displayed on the spatial light modulator 60 based on a control signal from the drive circuit 70. As described above, the control signal input from the drive circuit 70 to the spatial light modulator 60 is a signal related to the display of the modulation pattern.

The spatial light modulator 60 displays, for example, a lens pattern as a modulation pattern. For example, a Fresnel lens pattern may be used as the lens pattern. Hereinafter, in the present embodiment, it is assumed that the lens pattern is a Fresnel lens pattern, but the lens pattern may be other lens pattern such as an aspherical lens pattern. The curvature radius of the Fresnel lens pattern is, for example, a value obtained by doubling the focal length. The curvature radius is a positive value in a case of a concave mirror and a negative value in a case of a convex mirror. The focal length is a positive value in a case of a convex lens and a negative value in a case of a concave lens. In the spatial light modulator 60, the focal length of the Fresnel lens pattern as the modulation pattern is changed, so that the curvature radius of the Fresnel lens pattern is changed, and the distribution of angles of the light reflected by the spatial light modulator 60 is changed. When the distribution of angles of the light reflected by the spatial light modulator 60 changes, a degree of coincidence of paths of light before and after the reflection in the spatial light modulator 60 changes. In the spatial light modulator 60, as the degree of coincidence between the curvature radius of the Fresnel lens pattern and a distance between the spatial light modulator 60 and the diffraction grating 50 is higher, a wavelength band in which the paths of light before and after the reflection in the spatial light modulator 60 coincide with each other (a wavelength band in which coupling efficiency to the light source 11 is high) becomes wider. As described above, the spatial light modulator 60 can control the bandwidth of the light returned from the diffraction grating 50 to the light source 11 by controlling the distribution of angles of the reflected light based on the control signal. That is, the spatial light modulator 60 can control a spread of an optical spectrum by changing the focal length of the Fresnel lens pattern. As described above, the spatial light modulator 60 can control the spread of the optical spectrum without moving or aligning the optical components. Note that the bandwidth of the light returned to the light source 11 is determined, for example, from the wavelength dependency of the coupling efficiency to the light source 11, the wavelength dependency of the coupling efficiency to the optical fiber 92, the emission spectrum of the light source 11, and the like.

In a case of a reflective liquid crystal spatial light modulator, phase modulation by the spatial light modulator 60 is strongly affected by polarized light. The spatial light modulator 60 is disposed such that a polarization direction in which the phase modulation can be performed is an x direction or a y direction (that is, a direction parallel to a reflecting surface 60a in the spatial light modulator 60) in FIG. 1. The spatial light modulator 60 may be disposed such that the reflecting surface 60a and the reflecting surface in the diffraction grating 50 are parallel, or may be disposed so as not to be parallel. The polarization direction in which the phase modulation can be performed in the spatial light modulator 60 is made to coincide with, for example, a linear polarization direction of the light output from the light source 11. Furthermore, in the spatial light modulator 60, adjustment of an optical system or adjustment of a modulation pattern position may be performed such that a normal line extending from a center of the modulation pattern passes through a beam center of the light on the diffraction grating 50. The spatial light modulator 60 and the diffraction grating 50 may be disposed such that a curvature center related to the reflecting surface 60a of the spatial light modulator 60 coincides with the beam center of the light incident on the diffraction grating 50. More specifically, the spatial light modulator 60 and the diffraction grating 50 may be disposed such that a trajectory of the curvature center in a case where a curvature radius related to the reflecting surface 60a of the spatial light modulator 60 is changed intersects the beam center of the light incident on the diffraction grating 50. The curvature center related to the reflecting surface 60a of the spatial light modulator 60 is the curvature center of the modulation pattern displayed on the spatial light modulator 60.

The spatial light modulator 60 may display a predetermined surface shape correction pattern superimposed on the modulation pattern as necessary. Herein, the surface shape correction pattern is a pattern for correcting a shape of the reflecting surface 60a of the spatial light modulator 60. The spatial light modulator 60 may further superimpose and display a pattern for correcting aberration generated in the optical system. In addition, the spatial light modulator 60 may display modulation patterns (Fresnel lens patterns) having different focal lengths in the x direction and the y direction. In this case, for example, by optimizing the focal length in the y direction, the coupling efficiency of the light returned to the light source 11 can be increased. Note that in the spatial light modulator 60, the above-described control of the bandwidth of light (spread control of the optical spectrum) may be performed by changing only the focal length in the x direction.

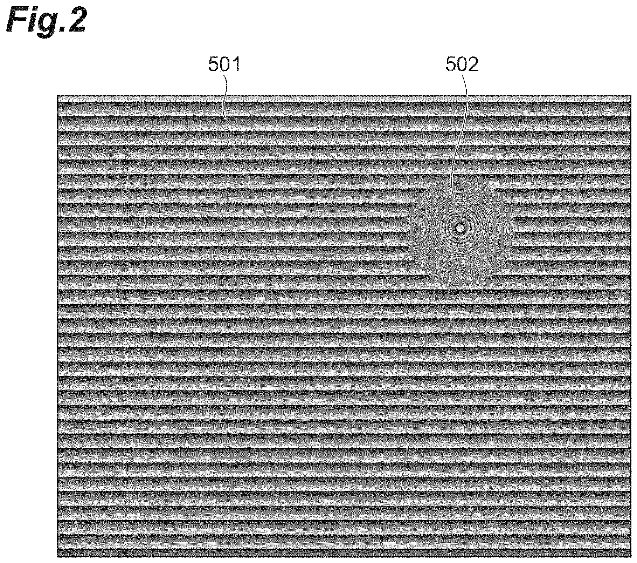

In the spatial light modulator 60, there is a problem that unmodulated light appears as 0th order light. As a countermeasure against such a problem, as illustrated in FIG. 2, a pattern in which a blazed diffraction grating pattern is superimposed on the Fresnel lens pattern may be used as the modulation pattern displayed on the spatial light modulator 60. FIG. 2 illustrates a blazed diffraction grating pattern 501 and a pattern 502 in which the blazed diffraction grating pattern is superimposed on the Fresnel lens pattern. In this case, +1-order light diffracted by the pattern 502 in which the blazed diffraction grating pattern is superimposed on the Fresnel lens pattern may be returned to the light source 11.

The optical fiber 92 is an optical fiber to which the light output from the light source 11 is input and which outputs the light. The light that is output from the light source 11 and reaches through the lens 91 is input to a first end portion 92a of the optical fiber 92. As described above, the lens 91 is a lens that condenses the light output from the light source 11 to the first end portion 92a (one end) of the optical fiber 92. The light input to the first end portion 92a (the light output from the light source 11) propagates through the optical fiber 92, reaches a second end portion 92b, is emitted to the outside from the second end portion 92b, and reaches the lens 40.

The light returned from the diffraction grating 50 and passing through the lens 40 is input to the second end portion 92b of the optical fiber 92. As described above, the lens 40 is a lens that condenses the light returned from the diffraction grating 50 to the second end portion 92b (the other end) of the optical fiber 92. The light input to the second end portion 92b (the light returned from the diffraction grating 50) propagates through the optical fiber 92, reaches the first end portion 92a, is emitted to the outside from the first end portion 92a, and reaches the lens 91.

The optical fiber 92 is, for example, a single-mode fiber. In a case where the optical fiber 92 is the single-mode fiber, a wavelength limiting function of an optical resonator can be exhibited in the single-mode fiber. Therefore, the wavelength limiting function is not required for the light source 11, and the degree of freedom in selecting the light source 11 increases. The optical fiber 92 may be a highly non-linear fiber. These fibers are fibers in which a non-linear effect is likely to occur. Examples of the non-linear effect include self-phase modulation, cross-phase modulation, modulation instability, stimulated Raman scattering, stimulated Brillouin scattering, four-wave mixing, supercontinuum generation, and the like. By using these non-linear effects, the degree of freedom of spectrum control of light can be improved, for example, by further expanding the spectrum.

The optical fiber 92 may be, for example, a dispersion compensation fiber. The dispersion compensation fiber is a fiber in which wavelength dispersion is suppressed, and is, for example, a single-mode fiber without mode dispersion. The optical fiber 92 may be, for example, a zero-dispersion wavelength fiber. The zero-dispersion wavelength fiber is, for example, an optical fiber such as a single-mode fiber, and is an optical fiber in which the center wavelength of output light coincides with the zero dispersion wavelength of the optical fiber. In general, the optical fiber may have two wavelengths (zero-dispersion wavelengths) at which wavelength dispersion is 0 (zero), and the zero-dispersion wavelength fiber refers to an optical fiber in which the center wavelength of output light coincides with the zero-dispersion wavelength of the optical fiber. According to these fibers, in light having a comb-like spectrum including, for example, a Fabry-Perot mode, the wavelength dependency of the interval between adjacent combs (longitudinal mode interval) can be reduced, and the longitudinal mode interval can be made uniform.

The length of the optical fiber 92 may be 0.1 times or more the length of the optical resonator in a case where the optical fiber 92 is not provided (for example, the length of the optical path from the light source 11 to the spatial light modulator 60 via the diffraction grating 50), and may be 10 mm or more as a specific length. The length of the optical fiber 92 may be 10 times or more the length of the optical resonator in a case where the optical fiber 92 is not provided, and may be 1 m or more as a specific length.

When the highly non-linear fiber is used as the optical fiber 92, the length of the optical fiber 92 may be 1 mm or more and 1 km or less. Since the loss in the case of the highly non-linear fiber is large, the length may be determined in consideration of the loss.

Next, the functions and effects of the light source apparatus 1 according to the present embodiment will be described.

The light source apparatus 1 includes: a light source 11 configured to output light; an optical fiber 92 to which the light output from the light source 11 is input and which outputs the light; a spatial light modulator 60 including an input unit for a control signal and configured to be able to control distribution of angles at which incident light is reflected based on the control signal; and a diffraction grating 50 configured to disperse the light output from the optical fiber 92 to cause the light to be incident on the spatial light modulator 60, and return at least a part of the light reflected by the spatial light modulator 60 to the light source 11. An optical resonator is formed by the light source 11 and the spatial light modulator 60, and the light returned to the light source 11 is output.

In the light source apparatus 1 according to the present embodiment, the light output from the light source 11 reaches the diffraction grating 50 via the optical fiber 92, is dispersed in the diffraction grating 50, and incident on the spatial light modulator 60. Then, at least a part of the light reflected by the spatial light modulator 60 is returned from the diffraction grating 50 to the light source 11, and the light returned to the light source 11 is output. As described above, since the optical fiber 92 is provided between the light source 11 and the diffraction grating 50, the length of the optical resonator (optical resonator length) formed by the light source 11 and the spatial light modulator 60 is longer than that in the configuration in which the optical fiber 92 is not provided. As a result, the longitudinal mode interval of a comb-like spectrum in the output light is reduced to bring the spectrum close to a continuous shape, and thus a dense spectrum can be formed. By increasing the optical resonator length with the optical fiber 92, it is possible to form the dense spectrum while securing optical stability. By forming the dense spectrum, wavelength resolution can be increased, and detection accuracy in spectroscopy such as absorption spectroscopy can be improved. Note that the absorption spectroscopy is a spectroscopy in which a sample is irradiated with light, and the absorbed wavelength and the amount thereof are calculated from the intensity of transmitted or reflected light.

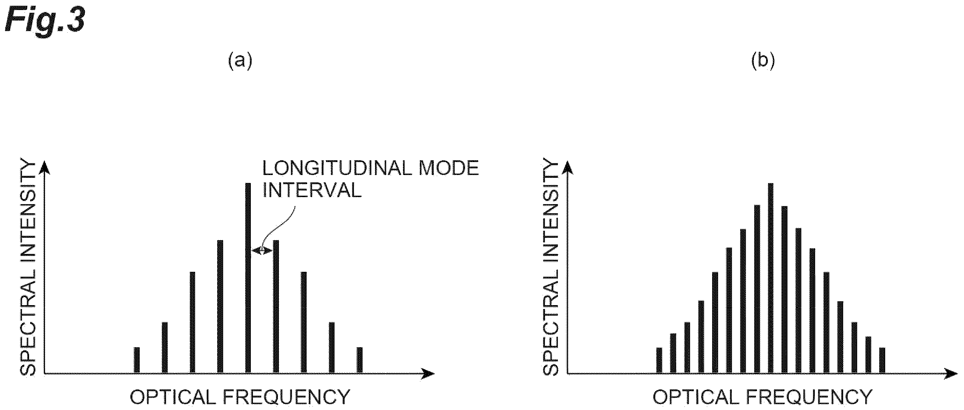

FIG. 3 is a diagram illustrating an effect of increasing an optical resonator length. FIG. 3(a) is a diagram illustrating the relationship between an optical frequency and spectral intensity in a configuration not including the optical fiber 92 (configuration not having a long optical resonator length), and FIG. 3(b) is a diagram illustrating the relationship between an optical frequency and spectral intensity in a configuration including the optical fiber 92. As illustrated in FIGS. 3(a) and 3(b), since light having a comb-like spectrum including a Fabry-Perot mode is output in an external resonator laser, the spectrum has a non-continuous shape, and a comb interval (longitudinal mode interval) occurs. In this regard, as is clear from comparison between FIGS. 3(a) and 3(b), by providing the optical fiber 92 to increase the resonator length, the above-described longitudinal mode interval can be reduced, and the spectrum can be brought close to a continuous shape. When the optical resonator length is simply increased, optical stability is impaired. However, by increasing the optical resonator length using the optical fiber 92, the spectrum can be brought close to a continuous shape while the optical stability is secured.

The optical fiber 92 may be a single-mode fiber or a highly non-linear fiber. According to such a configuration, a non-linear effect is likely to occur in the optical fiber 92. Examples of the non-linear effect include self-phase modulation, cross-phase modulation, modulation instability, stimulated Raman scattering, stimulated Brillouin scattering, four-wave mixing, supercontinuum generation, and the like. By using these non-linear effects, a degree of freedom of spectrum control of light is improved, for example, by further expanding the spectrum.

The optical fiber 92 may be a dispersion compensation fiber or a zero-dispersion wavelength fiber. According to such a configuration, the wavelength dependency of the longitudinal mode interval is reduced, and each longitudinal mode interval can be made uniform.

The length of the optical fiber 92 may be 0.1 times or more the length of the optical resonator in a case where the optical fiber 92 is not provided. When the optical fiber 92 has a sufficient length as described above, the length of the optical resonator can be appropriately increased by the optical fiber 92, to form the dense spectrum.

The length of the optical fiber 92 may be 10 times or more the length of the optical resonator in a case where the optical fiber 92 is not provided. According to such a configuration, the optical fiber 92 can be made longer, and a denser spectrum can be formed.

The length of the optical fiber 92 may be 10 mm or more. When the optical fiber 92 has a sufficient length as described above, the length of the optical resonator can be appropriately increased by the optical fiber 92, to form the dense spectrum.

The length of the optical fiber 92 may be 1 m or more. According to such a configuration, the optical fiber 92 can be made longer, and a denser spectrum can be formed.

The light source apparatus 1 may further include a lens 91 configured to condense the light output from the light source 11 to the first end portion 92a of the optical fiber 92, and a lens 40 configured to condense the light returned from the diffraction grating 50 to the second end portion 92b of the optical fiber 92. As described above, by adopting the configuration in which the light incident on both end portions of the optical fiber 92 is condensed by the lens, the replacement of the optical fiber 92 and the like can be easily performed.

In the light source apparatus 1, the bandwidth of the light returned from the diffraction grating 50 to the light source 11 may be controlled by controlling the distribution of angles of the light reflected by the spatial light modulator 60 based on the control signal. According to such a configuration, by changing the control signal, the distribution of angles at which the light is reflected by the spatial light modulator 60 is changed, and the bandwidth of the light returned from the diffraction grating 50 to the light source 11 can be changed. That is, according to such a configuration, the bandwidth of the light returned from the diffraction grating 50 to the light source 11 can be arbitrarily adjusted.

### Reference Signs List

- 1: Light source apparatus
- 11: Light source
- 40: lens (second lens)
- 50: Diffraction grating
- 60: Spatial light modulator (reflection unit)
- 91: Lens (first lens)
- 92: Optical fiber
- 92a: First end portion (one end)
- 92b: Second end portion (other end)

## Claims

1. A light source apparatus comprising:
a light source configured to output light;
an optical fiber to which the light output from the light source is input, the optical fiber being configured to output the light;
a reflection unit including an input unit for a control signal and configured to be able to control distribution of angles at which incident light is reflected based on the control signal; and
a diffraction grating configured to disperse the light output from the optical fiber to cause the light to be incident on the reflection unit, and configured to return, to the light source, at least a part of the light reflected by the reflection unit,
wherein
an optical resonator including the light source and the reflection unit is formed, and the light returned to the light source is output.

2. The light source apparatus according to claim 1, wherein the optical fiber is a single-mode fiber or a highly non-linear fiber.

3. The light source apparatus according to claim 1, wherein the optical fiber is a dispersion compensation fiber or a zero dispersion wavelength fiber.

4. The light source apparatus according to claim 1, wherein a length of the optical fiber is 0.1 times or more a length of the optical resonator in a case where the optical fiber is not provided.

5. The light source apparatus according to claim 4, wherein the length of the optical fiber is 10 times or more a length of the optical resonator in a case where the optical fiber is not provided.

6. The light source apparatus according to claim 1, wherein a length of the optical fiber is 10 mm or more.

7. The light source apparatus according to claim 6, wherein the length of the optical fiber is 1 m or more.

8. The light source apparatus according to any one of claims 1 to 7, further comprising: a first lens configured to condense the light output from the light source to one end of the optical fiber; and a second lens configured to condense the light returned from the diffraction grating to another end of the optical fiber.

9. The light source apparatus according to any one of claims 1 to 7, wherein a bandwidth of the light returned from the diffraction grating to the light source is controlled by controlling distribution of angles of the light reflected by the reflection unit based on the control signal.
